Europäisches Patentamt

European Patent Office

Office européen des brevets

(11) Numéro de publication: **0 402 245**
**A1**

## (12) DEMANDE DE BREVET EUROPEEN

(21) Numéro de dépôt: **90401530.2**

(22) Date de dépôt: **06.06.90**

(51) Int. Cl.⁵: **H05K 13/00**

(30) Priorité: **09.06.89 FR 8907685**

(43) Date de publication de la demande:
**12.12.90 Bulletin 90/50**

(84) Etats contractants désignés:
**CH DE GB IT LI**

(71) Demandeur: **J. LOUPOT S.A.**
**103, Route de Concarneau**

**F-29000 Quimper(FR)**

(72) Inventeur: **Francini, François**
**Cabinet Ballot-Schmit, 7, rue Le Sueuer**
**F-75116 Paris(FR)**

(74) Mandataire: **Ballot, Paul Denis Jacques**
**Cabinet Ballot-Schmit 7, rue le Sueur**
**F-75116 Paris(FR)**

(54) **Machine à préformer des composants électroniques ou électriques.**

(57) La présente invention concerne une machine à préformer à réglage automatique des longueurs de coupe et d'entraxe de cambrage.

La machine comprend des disques 15,16 de support des composants 2 qui sont entraînés en rotation, l'un des disques (16) étant déplaçable longitudinàlement sur un axe 10; elle comprend également des ensembles de coupe 28,29 comportant un disque d'appui (30,31) monté sur l'axe 10 et un disque (34,35) associé disposé sur un axe 27 ainsi que des disques de cambrage (non représentés) venant en regard de surfaces d'appui 23a, 23b des disques 15,16. Les ensembles de coupe et les disques de cambrage sont déplaçables de mainère à obtenir la longueur de coupe a et l'entraxe b.

FIG. 1

# MACHINE A PREFORMER DES COMPOSANTS ELECTRONIQUES OU ELECTRIQUES

La présente invention concerne une machine à préformer des composants électroniques ou électriques. Elle se rapporte plus particulièrement à une machine à préformer à réglage automatique des longueurs de coupe et d'entraxe de cambrage.

Les composants de circuits électriques ou électroniques sont constitués généralement par un corps prolongé de part et d'autre par des pattes permettant la fixation et la connexion de composants sur des circuits, tels que, par exemple, des résistances, inductances ou analogues. Ces composants sont généralement fabriqués à des dimensions standards et il est nécessaire d'adapter la longueur des pattes et le cambrage de celles-ci en fonction des circuits à réaliser.

Cette préformation des composants est réalisée soit manuellement, soit dans des machines à préformer permettant de couper les pattes à la longueur désirée et à les courber à l'entraxe de cambrage désiré. Toutefois, ces machines demandent des manipulations importantes pour modifier les dimensions de préformage, ces manipulations étant le plus souvent un démontage total ou partiel de la machine.

L'invention a notamment pour but de remédier à ces inconvénients en proposant une machine à préformer des composants de manière automatique, et permettant un réglage aisé et automatique des dimensions de préformage.

A cet effet, l'invention propose une machine à préformer des composants constitués par un corps prolongé de part et d'autre par des pattes de connexion, qui permet de couper lesdites pattes à une longueur déterminée et à les courber selon un entraxe de cambrage déterminé.

Cette machine se caractérise par le fait qu'elle comprend des disques de support des composants à préformer montés sur un premier axe et entraînés en rotation par ledit axe, au moins l'un des disques de support pouvant être déplacé sur l'axe selon la direction longitudinale de celui-ci, des disques de cambrage montés sur un second axe parallèle au premier, les bords des disques de cambrage venant en regard de surfaces d'appui montées sur le premier axe, des moyens de coupe comprenant deux ensembles constitués chacun d'un disque d'appui monté sur le premier axe et d'un disque formant contre-lame disposé sur un troisième axe parallèle aux deux premiers, les deux ensembles étant déplaçables selon la direction longitudinale des axes, et des moyens pour déplacer les disques support, les disques de cambrage et les ensembles de coupe. Selon une autre caractéristique de l'invention, les surfaces d'appui associées aux disques de cambrage sont formées sur une face des disques de support, par exemple par un épaulement formé sur les faces opposées de chacun des disques de support, cet épaulement étant concentrique au bord du disque de support.

Selon une autre caractéristique, les disques de support ont des bords dentés permettant d'amener un à un les composants dans les moyens de coupe et de cambrage. Avantageusement, le disque d'appui des ensembles de coupe ont également des bords dentés, les dentures de ces disques étant en correspondance avec les dentures des disques de support pour ainsi maintenir les branches des composants lors de leur coupe.

Selon une autre caractéristique, les moyens pour déplacer les disques de support, les ensembles de coupe et les disques de cambrage selon la direction longitudinale des axes, sont des vis micrométriques dont le curseur est relié aux disques à déplacer par, par exemple, des étriers ou analogues.

En outre, chaque disque de cambrage est solidaire en déplacement longitudinal du disque de support sur lequel est formé la surface d'appui ou épaulement associé.

Selon une autre caractéristique de l'invention, le second axe portant les disques de cambrage peut être déplacé pour modifier l'écartement entre cet axe et le premier axe, selon le diamètre des branches à cambrer. Dans un mode de réalisation préférée de l'invention le moyen de déplacement du second axe est un excentrique. De plus, pour prendre en compte l'épaisseur des branches du composant, les disques de cambrage peuvent être déplacés légèrement par rapport au disque de support associé. Ce déplacement est obtenu et contrôlé par glissement de deux plans inclinés solidaires respectivement du disque de cambrage et du disque de support.

Avantageusement, pour permettre un réglage facile de la longueur de coupe, le déplacement de l'ensemble de coupe est rendu solidaire du déplacement du disque support et disque de cambrage adjacent. Ainsi, il sera possible de fixer la longueur de coupe d'une branche par actionnement de la vis micrométrique associée à l'ensemble de coupe puis par solidarisation du déplacement de cet ensemble de coupe avec le déplacement des disques de support et de cambrage associé par actionnement de la vis micrométrique associée, fixer l'entraxe de cambrage sans modifier la longueur de coupe. Ce dispositif permet également une modification de l'entraxe de cambrage tout en conservant la longueur de coupe par simple actionnement de la vis micrométrique associée à l'ensemble disque support/disque de cambrage. Il est également aisément compréhensible que ce dispositif permet de fixer l'entraxe de cambrage puis par désolidarisation du déplacement de l'ensemble de coupe adjacent de celui du disque de support de régler la longueur de coupe.

Selon une nouvelle caractéristique de l'invention, la machine comprend un moyen pour recueillir et évacuer les déchets de coupe avantageusement constitué par des plaques formant goulotte ou déflecteur disposées au droit des moyens de coupe de part et d'autre des disques support.

En outre, pour permettre une éjection certaine des composants conformes, la machine de l'invention comprend au moins un moyen formant éjecteur, de préférence deux moyens dont l'un est disposé entre les disques de cambrage et constitué par une tige montée libre en rotation sur le second axe et formant ainsi une sorte de balancier de pendule, l'autre étant disposé entre les disques support en aval des moyens de cambrage par rapport au sens de rotation des disques support pour former une butée contre l'avancement des composants situés entre les disques support après passage dans les moyens de cambrage.

D'autres buts, avantages et détails de l'invention apparaîtront plus clairement au vu de la description détaillée d'un mode de réalisation particulier de l'invention donné uniquement à titre d'illustration et faite en référence aux figures associées dans lesquelles :

- la figure 1 est une vue schématique en coupe longitudinale, illustrant la position des ensembles de coupe dans un mode de réalisation d'une machine conforme à l'invention;

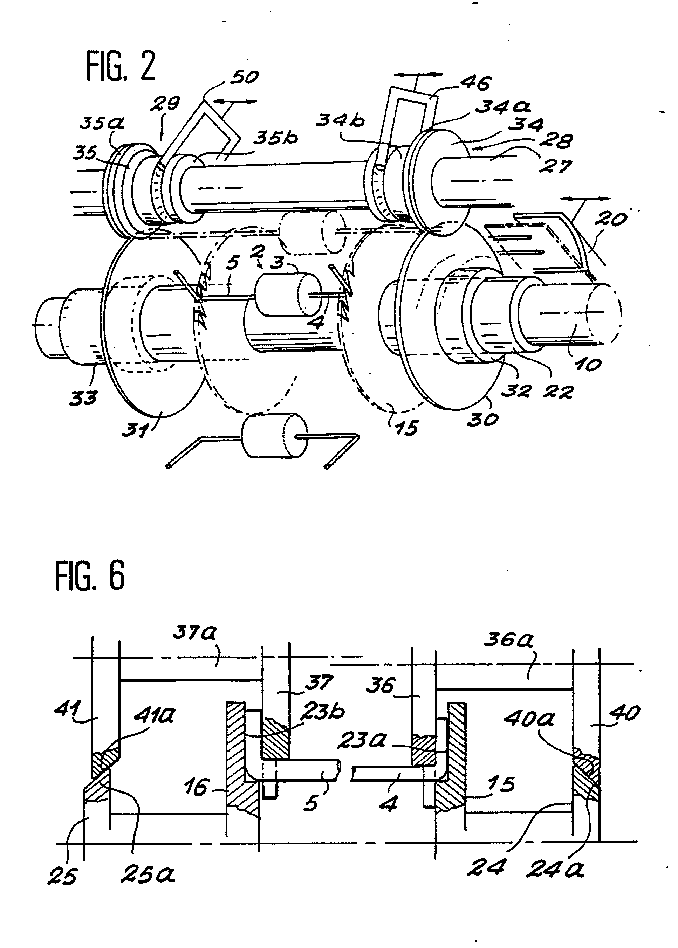

- la figure 2 est une vue schématique en perspective cavalière des ensembles de coupe illustrés dans la figure 1;

- la figure 3 est une vue schématique de côté de la machine de l'invention illustrant la position des différents axes;

- la figure 4 est une vue de dessus, illustrant la position des moyens de cambrage dans le mode de réalisation de la machine illustrée à la figure 1.

- la figure 5 est une vue de détail explicatif du cheminement des composants dans les moyens de coupe et de cambrage, et

- la figure 6 est une vue de détail explicatif du déplacement des disques de support et de cambrage.

Les figures annexées représentent un mode de réalisation d'une machine 1 à préformer des composants 2 comportant un corps 3 prolongé de part et d'autre par des branches 4,5. Ces composants sont également appelés composants axiaux et peuvent être, par exemple, des résistances, inductances ou analogues.

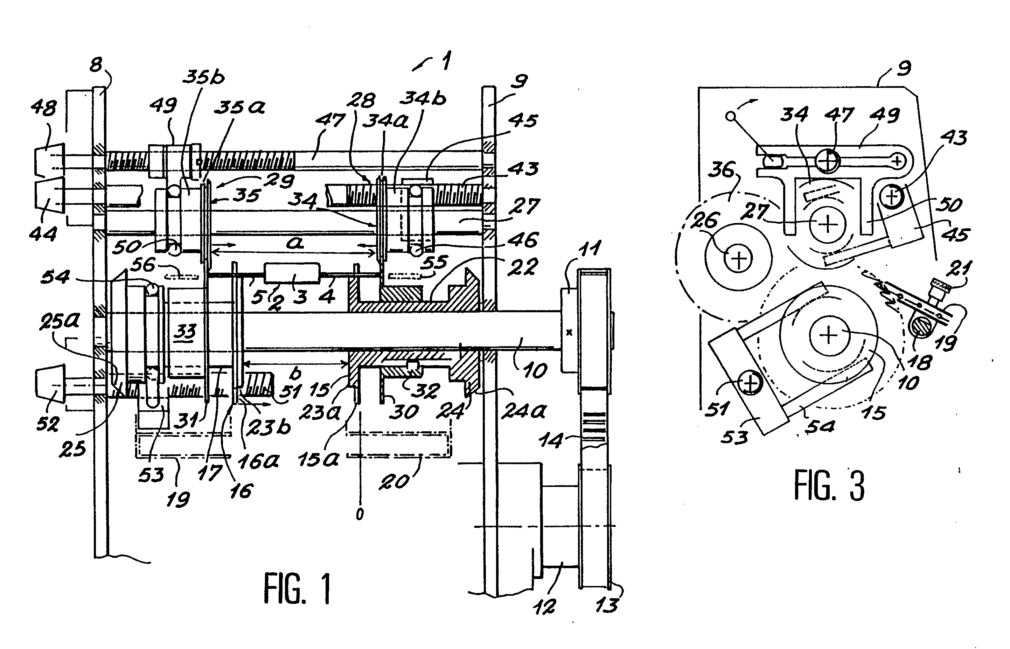

En se référant à la figure 1, on décrira tout d'abord la machine de l'invention et, plus particulièrement, les ensembles de coupe de cette machine.

La machine 1 à préformer comprend un châssis constitué par une embase (non représentée) et deux parois latérales 8,9.

Un premier axe 10 est monté entre les deux parois latérales et comprend à une de ses extrémités une poulie 11.

Cet axe 10 est entraîné en rotation par un moteur 12 muni d'une poulie 13 et une courroie 14. Ce mode d'entraînement est donné uniquement à titre d'exemple. Ainsi, il est possible, sans pour cela sortir du cadre de l'invention, de substituer à ces moyens d'entraînement, tout moyen d'entraînement automatique ou manuel.

Avantageusement, la vitesse d'entraînement de l'axe 10 peut être contrôlée et réglée à une valeur désirée selon la productivité de la machine. Cette productivité est surtout fonction de la nature des composants à préformer, diamètre des branches, mode d'alimentation par exemple.

Deux disques dentés 15,16 sont montés sur l'axe 10 entre les parois latérales 8,9. Avantageusement, le disque 15 est monté de manière fixe sur l'axe l0 pour ainsi servir de disque de référence pour le réglage des différentes longueurs de préformage.

Au contraire, le second disque 16 est monté sur un axe creux 17, concentrique à l'axe 10 et solidaire en rotation avec celui-ci, permettant ainsi un déplacement du disque 16 selon la direction longitudinale de l'axe 10 pour permettre de régler la longueur de l'entraxe de courbage des branches 4,5 du composant 2, longueur importante pour le préformage des composants.

Les disques 15,16 sont entraînés en rotation par l'axe 10. Les composants 2 sont alimentés sur les disques 15,16, appelés également disques de support, par tout moyen convenable.

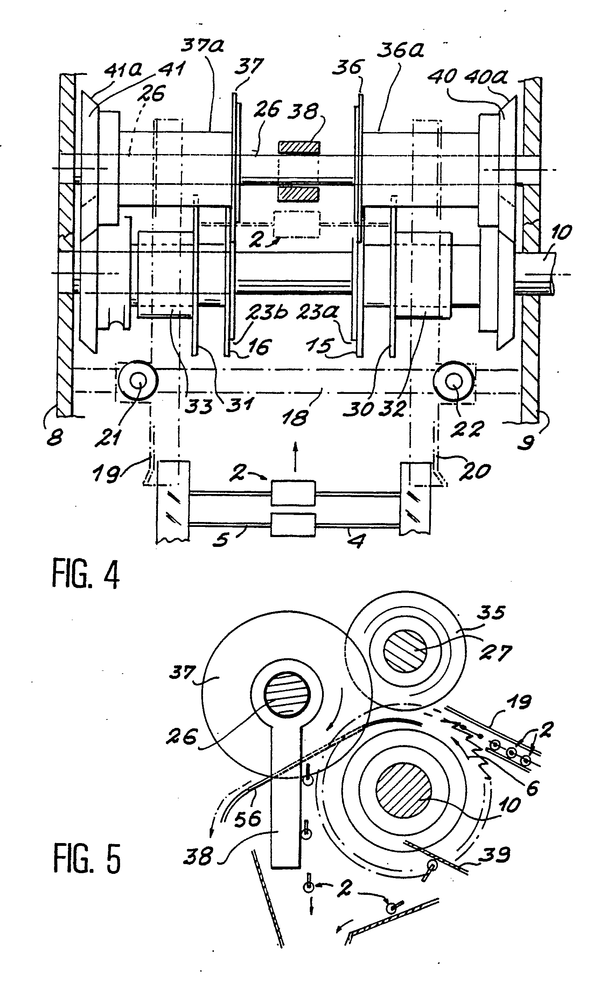

Ils peuvent être alimentés en vrac, un élément étant disposé dans chaque denture des roues de support soit manuellement, soit automatiquement au moyen de dispositifs d'alimentation. Il est également possible d'alimenter des composants en bandes comme représentées sur les figures annexées. A titre d'exemple, les moyens d'alimentation des composants en bandes, sont constitués par un axe 18 (figure 4) fixé sur les parois latérales 8,9 et deux guides bandes 19,20 montés sur l'axe 18. La position des guides bandes sur l'axe 18 est réglable et bloquée par des vis 21,22. Les guides bandes permettent d'amener les composants sur les disques de support 15 et 16. Ces guides bandes ont également l'avantage de pouvoir positionner les composants par rapport au disque de support 15 de référence.

Les disques 15,16 de support présentent sur leur face opposée 15a, 16a un épaulement 23a, 23b situé sensiblement à mi-diamètre.

Toutefois, la position de l'épaulement 23 n'est pas critique, mais il doit avoir un profil cylindrique.

Dans le mode de réalisation représenté, le disque 15 de support est également monté sur un axe creux 22 concentrique à l'axe 10.

Les extrémités de chacun des axes creux 22 et 17 comprennent un disque 24,25 définissant un cône avec un bord présentant une surface inclinée 24a, 25a, comme illustré à la figure 6.

La machine de l'invention comprend un second axe 26 disposé entre les parois latérales illustré aux figures 3,4 et un troisième axe 27 disposé également entre les parois latérales 8,9 du châssis.

Le second axe 26 et troisième axe 27 sont parallèles au premier axe 10 et disposés autour de celui-ci, comme illustré à la figure 3.

Ainsi, en prenant comme référence le sens de rotation du premier axe 10, représenté par une flèche 6 dans les figures 3 et 5, le troisième axe 27 est situé après l'alimentation des composants 2 sur les disques support 15,16, le second axe 26 étant disposé en aval du troisième axe 27.

La machine 1 de l'invention comprend deux ensembles de coupe 28,29 composés respectivement par un disque 30,31 monté sur un axe creux 32,33 concentrique aux axes 22 et 17 et à l'axe 10 et solidaire en rotation de ceux-ci. Ces disques 30, 31 sont montés de part et d'autre des disques de support 15,16 et entre ceux-ci et les cônes 24,25 associés. Ces ensembles de coupe 28,29 comprennent un disque 34,35 formant contre-lame dont le bord comporte une gorge 34a, 35a dans laquelle pénètre le bord du disque 30,31 associé. Ces disques 34,35 sont montés sur le troisième axe 27, par exemple, au moyen d'un axe creux formant douille 34b, 35b permettant ainsi un déplacement longitudinal de ces disques sur l'axe 27. Avantageusement, les disques 30,31 ont un bord denté permettant de maintenir les branches 4,5 des composants lors de l'étape de coupe.

En se référant à la figure 4, la machine 1 comprend également des disques de courbage 36,37 montés par l'intermédiaire d'axes creux 36a,37a sur le second axe 26. Ces disques sont situés entre les disques 15,16 de support et leur bord vient au droit des épaulements 23a,23b. Ainsi, quand les pattes 4,5 des composants supportés par les disques 15,16 viennent en contact des disques de cambrage 36,37, elles sont progressivement courbées, le courbage étant achevé quand ces branches sont situées entre l'épaulement et les bords des disques de cambrage 36,37.

De plus, comme illustré à la figure 6, des disques 40,41 en forme de cône sont fixés à l'extrémité des axes creux 36a,37a. Ces disques présentent un bord 40a, 41a à surface inclinée venant au droit des bords 24a, 25a des cônes 24, 25.

Par ailleurs, le second axe 26 peut être déplacé par rotation d'un excentrique (non représenté) pour écarter les disques de cambrage 36,37 des épaulements 23a,23b selon le diamètre des pattes 4,5 des composants. De ce fait, les surfaces inclinées 24a,25a et 40a,41a glissent l'une sur l'autre permettant ainsi de contrôler et limiter le déplacement longitudinal des disques de cambrage par rapport aux disques de support 15,16, comme cela est illustré sur la figure 6.

La machine 1 comprend également des éjecteurs 38,39 (figures 4,5) permettant d'assurer l'éjection et la récupération des composants préformés.

Dans le mode de réalisation illustré aux figures 4 et 5, l'éjecteur 38 est situé entre les disques de cambrage 36,37 et est constitué par une barre, avantageusement lourde, montée en rotation libre autour du second axe 26 et formant ainsi une sorte de balancier de pendule entre les deux disques de cambrage 36,37.

De ce fait, si un composant reste accroché aux disques de cambrage par l'élasticité de leur branche, la barre vient buter contre le corps du composant et ainsi vaincre la force d'élasticité des branches et provoque la chute des composants.

Le second éjecteur 39 est, dans l'exemple illustré à la figure 5, une butée fixée sur le châssis de la machine et qui forme une saillie entre les disques 15,16 de support provoquant la chute des composants préformés qui sont restés coincés entre les disques de support.

Selon l'invention, la machine comprend des moyens pour déplacer les différents disques décrits précédemment pour régler la longueur de coupe a des composants et l'entraxe de cambrage b. En effet, ces deux dimensions permettent de contrôler la position des pattes 4,5 de connexion des composants et également la longueur de ces pattes.

La machine comprend un premier moyen pour déplacer l'ensemble de coupe adjacent au disque 15 de support de référence. Ce moyen est constitué par une vis micrométrique 43 actionnée par un vernier 44 et dont le curseur 45 entraîne en déplacement le disque 34 formant contre-lame au moyen d'un étrier 46 et le disque d'appui 30 associé.

Ainsi, par actionnement de la vis micrométrique 43 et affichage de la longueur sur le vernier 44 préalablement étalonné, il est possible de régler la distance entre le disque support 15, c'est-à-dire le disque de cambrage, et l'ensemble coupe 28, cette distance correspondant à la longueur de coupe et donc à la longueur des pattes de connexion.

De manière analogue, le second ensemble de coupe 29 adjacent à l'autre disque 16 de support est déplacé au moyen d'une seconde vis micrométrique 47 actionnée par un second vernier 48, un curseur 49 de la vis micrométrique étant connecté au disque 35 formant contre-lame par un étrier 50, qui entraîne lui-même le disque 31 monté sur l'axe 10.

Comme illustré à la figure 3, il est possible, dans un mode de réalisation préféré de l'invention, de désolidariser le curseur 49 de la vis micrométrique 47 pour ainsi déplacer l'ensemble de coupe 29 par déplacement du disque 16 et du disque de cambrage 37 pour faciliter le réglage et le positionnement du disque 16 et de l'ensemble de coupe 29, comme expliqué ci-dessous.

Enfin, comme illustré à la figure 1, la machine comprend un troisième moyen de déplacement constitué par une troisième vis micrométrique 51 actionnée par un troisième vernier 52 et dont le curseur 53 comprend un étrier 54 entraînant en déplacement l'ensemble disque de cambrage 37 et le disque de support 16 mobile pour ainsi fixer la longueur b de l'entraxe de courbage, ou l'écartement entre les disques 15 et 16.

Ainsi, avant l'alimentation des composants, la longueur de coupe a et la longueur b de l'entraxe de cambrage sont fixées aisément par actionnement des verniers qui sont avantageusement étalonnés pour indiquer directement les longueurs de coupe ou d'entraxe.

De plus, il est facilement compréhensible qu'une de ses longueurs peut être modifiée très facilement sans que l'autre longueur soit déréglée et cela sans démontage d'une pièce de la machine.

En effet, si la longueur d'entraxe de cambrage b doit être modifiée, il suffit d'afficher la nouvelle longueur sur le vernier 52 et de régler l'écartement entre l'ensemble 29 et le disque 16 par affichage de celui-ci sur le vernier 48. Avantageusement, l'ensemble de coupe 29 est déplacé à sa position 0 avant ou après le déplacement du disque 16 et "remise à zéro" du vernier 48 par désolidarisation du curseur 49 et de la vis micrométrique 47.

Par ailleurs, pour éviter un mélange entre les déchets de coupe et les composants conformés, des plaques 55,56 ou déflecteurs formant récepteur et collecteur pour les déchets sont fixés de part et d'autre des ensembles de coupe 28,29 ou disques, au droit des disques 34,35 formant contre-lame. Ces plaques se prolongent avantageusement vers le bas du châssis pour former une goulotte de collection de ces déchets de coupe qui sont ensuite récupérés par chute dans un récipient non représenté.

Les différents éléments et agencement décrits ci-dessus ne sont donnés qu'à titre d'exemple et tous les moyens équivalents aux moyens décrits peuvent être utilisés sans pour cela sortir du cadre de l'invention.

## Revendications

1. Machine à préformer des composants constitués par un corps prolongé de part et d'autre par des pattes de connexion par coupe des pattes à une longueur déterminée et cambrage de celles-ci avec un entraxe de cambrage déterminé, des moyens pour alimenter des composants dans la machine, des moyens de coupe des pattes de connexion des composants et des moyens de cambrage de ces pattes, caractérisée en ce que les moyens d'alimentation des composants comprennent des disques (15,16) de support des composants (2) à préformer montés sur un premier axe (10), ledit axe et lesdits disques (15,16) de support étant entraînés en rotation, au moins l'un des disques (16) de support étant déplaçable selon la direction longitudinale de l'axe (10), les moyens de cambrage comprenant des disques de cambrage (36,37) montés sur un second axe (26) parallèle au premier axe (10), les bords des disques de cambrage (36,37) venant en regard de surfaces d'appui (23a,23b) prévues sur les disques de support (15,16) montées sur le premier axe (10), des ensembles de coupe (28,29) comprenant chacun un disque d'appui (30,31) monté sur le premier axe (10) et un disque (34,35) associé formant contre-lame disposé sur un troisième axe (27) parallèle aux deux premiers, les deux ensembles de coupe (28,29), les disques de cambrage (36,37) étant déplaçables selon la direction longitudinale des axes (26,27), et des moyens pour déplacer le ou les disques support, les disques de cambrage et les ensembles de coupe comprenant des vis micrométriques (43,47,51) dont les curseurs (45,49,53) comprennent un étrier (46,50,54) relié au disque à déplacer.

2. Machine selon la revendication 1, caractérisée en ce que les surfaces d'appui (23a,23b) sont constituées par un épaulement formé sur la face (15a,16a) des disques de support (15,16).

3. Machine selon la revendication 1 ou 2, caractérisée en ce que l'épaulement est concentrique au bord du disque (15,16) sur lequel il est formé.

4. Machine selon l'une des revendications précédentes, caractérisée en ce qu'elle comprend des moyens pour déplacer le second axe (26) supportant les disques de cambrage (36,37) pour modifier l'écartement entre le premier axe (10) et le second axe (26).

5. Machine selon l'une des revendications précédentes, caractérisée en ce que les disques de support (15,16) ont des bords dentés.

6. Machine selon la revendication 5, caractérisée en ce que les disques d'appui (30,31) des ensembles de coupe (28,29) ont des bords dentés.

7. Machine selon l'une des revendications 1 à 6, caractérisée en ce que les disques de cambrage (36,37) et les disques de support (15,16) associé sont déplacés par un moyen de déplacement commun (51,53,54).

8. Machine selon l'une des revendications précédentes caractérisée en ce que un des disques de support (15) et le disque de cambrage (36) associé sont montés fixes sur leur axe (10,26) respectif.

9. Machine selon la revendication 4, caractérisée en ce que le moyen pour déplacer le second axe (26) est un excentrique.

10. Machine selon l'une des revendications précédentes, caractérisée en ce que l'écartement entre le disque de cambrage (36,37) et le disque de support (15,16) associé est contrôlé par glissement de cônes (25,41,24,40) solidaires de chacun de ces disques.

11. Machine selon l'une des revendications précédentes, caractérisée en ce que l'ensemble de coupe (28,29) peut être déconnecté de son moyen de déplacement.

12. Machine selon l'une des revendications précédentes, caractérisée en ce qu'elle comprend des moyens (55,56) pour récupérer les déchets de coupe.

13. Machine selon l'une des revendications précédentes, caractérisée en ce qu'elle comprend des éjecteurs (38,39) des composants (2) préformés.

14. Machine selon la revendication 13, caractérisée en ce que l'un des éjecteurs (38) est constitué par une tige montée libre en rotation sur le second axe (26) entre les disques de cambrage (36,37).

15. Machine selon la revendication 1, caractérisée en ce que les vis micrométriques sont équipées de vernier (44,48,52).

16. Machine selon l'une des revendications précédentes, caractérisée en ce qu'elle comprend des moyens d'alimentation des composants en vrac.

17. Machine selon l'une des revendications 1 à 15, caractérisée en ce qu'elle comprend des moyens d'alimentation des composants en bande.

18. Machine selon la revendication 17, caractérisée en ce que les moyens d'alimentation comprennent des guides bandes (19,20) montés de manière réglable sur un axe (18).

FIG. 3

FIG. 1

## FIG. 2

## FIG. 6

FIG. 4

FIG. 5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | US-A-4633919 (SHILOH)<br>* colonne 3, ligne 61 - colonne 4, ligne 39 *<br>* colonne 4, ligne 64 - colonne 5, ligne 17 *<br>* colonne 5, ligne 39 - colonne 6, ligne 42; revendications 1-3, 6-14; figures 1-11 *<br>--- | 1, 4, 5,<br>9, 13<br>16-18 | H05K13/00 |
| A | US-A-2592019 (HORACE E. FARNETT)<br>* colonne 1, lignes 35 - 39 *<br>* colonne 2, lignes 14 - 17; figure 1 *<br>--- | 1, 5, 6,<br>12 | |
| A | US-A-3403540 (T.F. SCHWARTZ)<br>* colonne 6, lignes 5 - 15; figure 11 *<br>----- | 1-3, 5 | |
| | | | **DOMAINES TECHNIQUES RECHERCHES (Int. Cl.5 )**<br><br>H05K |

Le présent rapport a été établi pour toutes les revendications

| Lieu de la recherche | Date d'achèvement de la recherche | Examinateur |
|---|---|---|
| LA HAYE | 07 AOUT 1990 | RIEUTORT A.S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

&: membre de la même famille, document correspondant

EPO FORM 1503 03.82 (P0402)